# EUROPÄISCHE PATENTSCHRIFT

(11) **EP 0 352 545 B1**
(45) Veröffentlichungstag und Bekanntmachung des Hinweises auf die Patenterteilung: **03.11.1993**
(21) Anmeldenummer: 89112717.7
(22) Anmeldetag: 12.07.1989
(51) Int. Cl.: C23C 14/06, C23C 16/30, C23C 28/04, C23C 16/50, C23C 14/32

(54) **PVD-Beschichtung sowie Verfahren zu deren Aufbringung**
PVD coating and method for depositing it
Revêtement PVD et son procédé de dépôt

(30) Priorität: 23.07.1988 DE 3825399
(43) Veröffentlichungstag der Anmeldung: 31.01.1990
(73) Patentinhaber: Leyendecker, Toni, Dr.-Ing., D-52070 Aachen (DE)
(72) Erfinder: Leyendecker, Toni, Dr. Ing., D-5100 Aachen (DE); Esser, Stefan, D-5102 Würselen (DE); Lemmer, Oliver, D-5100 Aachen (DE)
(74) Vertreter: Patentanwälte Wenzel & Kalkoff

(56) Entgegenhaltungen:
- EP-A- 0 323 434
- WO-A-87/05948
- THIN SOLID FILMS, Band 153, Oktober 1987, Seiten 67-74, Elsevier Sequoia, Lausanne, CH; H. FRELLER et al.: "TixAl1-xN films deposited by ion plating with an arc evaporator"
- JOURNAL OF VACUUM SCIENCE AND TECHNOLOGY, Band A 4, Nr. 6, November/Dezember 1986, Seiten 2701-2705, American Vacuum Society, New York, US; H.A. JEHN et al.: "Morphology and properties of sputtered (Ti,Al)N layers on high speed steel substrates as a function of deposition temperature and sputtering atmosphere"
- JOURNAL OF VACUUM SCIENCE AND TECHNOLOGY, Band A 4, Nr. 6, November/Dezember 1986, Seiten 2695-2700, American Vacuum Society, New York, US; O. KNOTEK et al.: "On structure and properties of sputtered Ti and Al based hard compound films"
- JOURNAL OF SOLID STATE CHEMISTRY, Band 70, Nr. 2, Oktober 1987, Seiten 318-322, Academic Press, Inc.; O. KNOTEK et al.: "On the structure of (Ti, Al)N-PVD coatings"

## Beschreibung

Die Erfindung betrifft eine PVD-Beschichtung oder Plasma-CVD-Beschichtung an einem Werkzeug oder Bauteil mit mindestens einer Kante im Bereich der Beschichtung, die aus einem Mehrkomponenten-Hartstoff mit mehr als einem metallischen Element besteht. Außerdem betrifft die Erfindung ein Verfahren zur Beschichtung eines derartigen Werkzeuges oder Bauteils.

Zur Leistungssteigerung von Schneidwerkzeugen, Fräsern, Stanzstempeln, Bohrern und sonstigen Stanz- und Schneidewerkzeugen sowie Verschleißteilen aller Art werden in zunehmendem Maße Hartstoffbeschichtungen eingesetzt, die aus hauchdünnen Überzügen von einigen µm bestehen und eine beachtliche Erhöhung der Standzeiten dieser Werkzeuge ermöglichen. Die Hartstoffe bestehen aus einem oder mehreren Metalloiden wie Sauerstoff, Stickstoff, Kohlenstoff, Bor oder Silizium sowie einem oder mehreren metallischen Elementen. Die relativ hohen Kosten dieser Hartstoffbeschichtungen sind bei bestimmten Anwendungsfällen infolge der drastisch erhöhten Standzeiten durchaus wirtschaftlich.

Das Aufbringen derartiger Hartstoffbeschichtungen erfolgt in einer Vakuumkammer, in der ein Plasma, also ein aus Ionen bestehender Partikeldampf erzeugt wird,der wiederum mit Hilfe elektrischer Felder oder mit Hilfe eines Magnetronfeldes auf das zu beschichtende Werkstück aufgebracht wird. Für die Erzeugung des Plasmas steht ein Lichtbogen, ein Elektronenstrahl oder ein Bombardement von Edelgasionen auf eine Kathode zur Verfügung, die auch Target genannt wird und je nach Verfahren ohne flüssige Phase oder über die flüssige Phase das genannte Plasma hervorbringt.

Zusätzlich kann die Vakuumkammer mit einem reaktiven Gas teilgefüllt werden, das Bestandteil des späteren Hartstoffsystems wird. Derartige Verfahren sind unter dem Begriff PVD-Verfahren (physical vapour deposition) bekannt. Wird das Plasma in einem Vakuumbehälter erzeugt, in den die Bestandteile des späteren Hartstoffsystems gasförmig eingeleitet werden, so ist das Verfahren unter dem Begriff Plasma-CVD-Verfahren bekannt, wobei das Kürzel CVD für chemical vapour deposition steht.

Zu Beginn dieser Entwicklung wurden in erster Linie Titannitride als Hartstoff eingesetzt. Damit wurden bereits hervorragende Verbesserungen gegenüber HSS-Stählen und Hartmetallen erzielt. Die weitere Entwicklung dieser Hartstoffbeschichtungen hat gezeigt, daß noch bessere Ergebnisse erzielt werden, wenn Hartstoffe mit mehr als einer metallischen Komponente eingesetzt werden, z. B. bei einem System aus Aluminium, Titan und Stickstoff oder aus Zirkon, Titan und Stickstoff, wobei Zusätze von weiteren Metallen oder Metalloiden u. a. zur Stabilisierung verwendet werden können. Die damit erzielten Standzeiten von Werkzeugen und Verschleißteilen haben eine weitere Verbesserung erfahren, wobei an dieser Stelle auf eine Theorie zur Erklärung dieser Vorgänge verzichtet wird. Wichtig ist, daß bei allen PVD- und Plasma-CVD-Verfahren im Kantenbereich von Werkzeugen und Bauteilen eine Inhomogenität der Zusammensetzung des Hartstoffes eintritt, deren Entstehung relativ leicht zu erklären ist, die jedoch bisher mit allen zu Gebote stehenden Mitteln verhindert wird.

Bei der Aufbringung der verdampften Partikel in der gewünschten Zusammensetzung aus dem dampfförmigen Zustand auf das Werkzeug oder Bauteil mit Hilfe elektrischer Felder oder mit Hilfe eines Magnetronfeldes, das durch eine Überlagerung magnetischer Feldlinien über ein elektrisches Feld die Wirkung eines elektrischen Feldes verstärkt, tritt im Kantenbereich die bei allen elektrischen Feldern zu beobachtende Spitzenwirkung auf, die sich darin äußert , daß an dieser Stelle eine besondere Dichte der Feldlinien vorhanden ist. Das führt im Ergebnis im Kantenbereich zu einer intensiveren Belegung der Kante mit Ionen. Diese Feststellung gilt sowohl für die Partikel der späteren Hartstoffschicht, die zur Anlagerung an das Werkzeug in den atomaren Zustand übergeführt werden, als auch für reine Beschuß- und Trägerionen wie z. B. Argonionen bei einer Kathodenzerstäubung mit Hilfe dieses Edelgases, wobei die Argonionen eine Verdichtung der bereits abgelagerten Hartstoffpartikel bewirken.

Ein Mittel zur Vermeidung einer Inhomogenität im Bereich der Kante besteht darin, daß ein relativ schwaches elektrisches Feld eingesetzt wird und zur Kompensation eine besonders starke Ionisierung des Kammerinhaltes herbeigeführt wird. Die erzielbaren Beschichtungen zeigen befriedigende Ergebnisse, wobei die Spitzenwirkung im Kantenbereich aufgrund der Schwäche des elektrischen Feldes soweit gemindert ist, daß von einer homogenen Beschichtung auch im Kantenbereich im Vergleich zu den Bereichen außerhalb des Kantenbereiches gesprochen werden kann.

Es ist Aufgabe der Erfindung, eine PVD-Beschichtung und ein Verfahren zur Aufbringung dieser Beschichtung vorzuschlagen, durch die bzw. durch das noch eine wesentliche Verbesserung der Beschichtungsgüte erzielt wird.

Zur Lösung dieser Aufgabe schlägt die Erfindung vor, daß die Zusammensetzung der Beschichtung im Bereich jeder Kante im Vergleich zu den übrigen Bereichen einen Konzentrationsunterschied der metallischen Elemente aufweist, der mindestens 2 Massen% beträgt. Bezüglich des Verfahrens zur Beschichtung eines Werkzeuges schlägt die Erfindung vor, daß das Potential des Plasmas gegenüber dem Werkzeug so stark gewählt wird, daß durch den Ionenbeschuß infolge der Spitzenwirkung der Kante auf die Kante der Konzentrationsunterschied selbsttätig herbeigeführt wird.

Die Erfindung beruht auf der überraschend gefundenen Tatsache, daß die nachweisliche Inhomogenität, die sich in einem Konzentrationsunterschied der metallischen Werkstoffe des Hartstoffsystems äußert, gerade zu Hartstoffbeschichtungen führt, die wesentlich widerstandsfähiger gegen Verschleiß sind als exakte, homogene Beschichtungen an dieser Stelle, obwohl die beabsichtigte, stöchiometrisch korrekte Zusammensetzung im Kantenbe reich nicht erzielt wird. Es besteht keine Verpflichtung, dieses überraschende Ergebnis physikalisch zu erläutern, es wird jedoch unverbindlich die Vermutung geäußert, daß sich im Kantenbereich während der Beschichtung etwa folgender Prozeß abspielt: Nachdem das Maß der Ionisation und der elektrischen Feldstärke so gewählt worden ist, daß es im Kantenbereich zu einer deutlichen Spitzenwirkung und damit zu einem deutlichen Überbombardement durch Ionen kommt, führen die in großer Zahl und mit großer Heftigkeit auftretenden Ionen zu einer erwünschten Verdichtung der bereits an der Kante anhaftenden Partikel, wobei insbesondere die Partikel mit einem geringeren Atomgewicht wieder vom Kantenbereich infolge des Bombardements entfernt werden und dadurch der Konzentrationsunterschied eintritt. Es ist dabei unerheblich, ob das Bombardement durch die aufzutragenden Partikel selbst oder durch Edelgasionen oder dgl. hervorgerufen wird.

Im Ergebnis findet also im Kantenbereich eine überdurchschnittliche Verfestigung des Hartstoffsystems zu Lasten einer stöchiometrischen ausgewogenen Zusammensetzung statt. Die Nachteile infolge der Inhomogenität werden übertroffen von den Vorteilen infolge der Verdichtung und damit auch infolge einer verbesserten Haftung der Hartstoffschicht an dieser Stelle. Kontrollversuche haben gezeigt, daß erfindungsgemäß beschichtete Spiralbohrer eine deutliche Verbesserung der Standzeit erreicht haben, wenn sie mit homogen beschichteten Hartstoffsystemen derselben Zusammensetzung oder einer ähnlichen Zusammensetzung verglichen wurden.

Neben der Beschichtung von HSS-Stählen und Hartmetallen können auch Cermets, Keramiken oder Zusammensetzungen daraus mit einem Film eines Hartstoffsystems überzogen werden. In bestimmten Anwendungsfällen kann es vorteilhaft sein, das Hartstoffsystem gemäß der Erfindung nicht direkt auf das Grundmaterial aufzubringen sondern auf eine vorher aufgebrachte Zwischenschicht, die aus Ti-N, Ti-C-N, Ti-C oder dgl. besteht. Sie wirkt ausgleichend auf die Materialeigenschaften zwischen dem Grundwerkstoff und der verfestigten Kantenbeschichtung gemäß der Erfindung, so daß die Beschichtung duktiler ist und so Schlagbeanspruchungen besser standhält.

Besonders gut hat sich ein Hartstoffsystem bewährt, das zwei metallische Elemente enthält, nämlich Aluminium und Titan, wobei ein Konzentrationsunterschied als Absenkung des Aluminiumgehaltes um bis zu 10 Massen% festgestellt werden konnte. Das gesamte System enthält Aluminium, Titan und Stickstoff, wobei gegebenenfalls Zirkon oder Vanadium zur Stabilisierung enthalten sein können. Im übrigen werden die besten Ergebnisse erzielt, wenn Elemente der Nebengruppen IVa bis VIa des Periodensystems verwendet werden, da diese Elemente untereinander ähnlich sind und im festen Zustand miteinander mischbar sind.

Sehr gute Beschichtungsergebnisse werden beim PVD-Verfahren erzielt, wenn für die Kathodenzerstäubung Argon eingesetzt wird, wobei der Stickstoff als reaktives Gas zur Bildung der Nitride unter vorgegebenen Partialdrücken ebenfalls in die Vakuumkammer eingegeben wird. Bei einer guten Ionisierung, die durch Ionisierungshilfen auf einem hohen Niveau gehalten wird, sind Potentiale zwischen dem Plasma und dem Werkzeug, das auch Substrat genannt wird, von -50 V bis -150 V anwendbar, wobei besonders gute Ergebnisse bei einem Potential von ca. -100 V erzielt wurden. Es kommt dann zu der bisher mit allen Mitteln vermiedenen und von der Erfindung favorisierten Spitzenwirkung im Bereich der Kanten der Werkzeuge, die offenbar für die hohe Güte der Beschichtung verantwortlich ist.

Im Falle von Plasma-CVD-Beschichtungen werden höhere Potentiale zwischen dem Plasma und dem Substrat benötigt, die einige 100 V bis zu 2000 V betragen können.

### Beispiel

In einer mit Argon gefüllten Vakuumkammer wurden Spiralbohrer von 8 mm Durchmesser eine Stunde lang durch Kathodenzerstäubung beschichtet, wobei als Target (Kathode) Titan-Aluminiumsintermaterial verwendet wurde. Zur Bildung des gewünschten Hartstoffsystems wurde als reaktives Gas Stickstoff unter einem vorgegebenen Partialdruck in die Vakuumkammer eingeleitet. Bei guter Ionisierung wurde mit einem Potential von -100 V zwischen dem Plasma und dem Substrat (Spiralbohrer) innerhalb der einstündigen Beschichtungsdauer ein Schichtaufbau von 3 µm erzeugt.

Nach der Beschichtung war im Kantenbereich deutlich ein rötlicher bis gelblicher Saum sichtbar, der sich deutlich gegenüber der typischen Farbe von schwarzgrau für dieses Hartstoffsystem abhob. Er läßt auf eine Ausdünnung des Aluminiums an dieser Stelle schließen, da Titannitride diese rötliche oder gelbliche Färbung aufweisen. Der Konzentrationsunterschied des Aluminiums an dieser Stelle gegenüber den restlichen schwarzblauen Schichten außerhalb der Kantenbereiche betrug ca. 6 Massen%. Die in dieser Weise beschichteten Spiralbohrer wurden Standzeittests unterworfen. U. a. waren Vergleichsmuster zur Hand, die mit demselben Hartstoffsystem in derselben Schichtdicke beschichtet waren, deren Zusammensetzung homogen war, also ideal war im Bereich der Flächen und Kanten. Außerdem wurden zum Vergleich Spiralbohrer desselben Durchmessers untersucht, die mit Titannitrid beschichtet waren.

Dabei hat sich gezeigt, daß die erfindungsgemäße Beschichtung gegenüber der homogenen Beschichtung eine Standzeit erzielte, die um den Faktor 1,5 höher lag, während dieser Faktor gegenüber den mit Titannitrid beschichteten Spiralbohrern 3 betrug. Es kann also eine deutliche Steigerung der Standzeit um annähernd 50 % bei den erfindungsgemäß beschichteten Bohrern gegenüber demselben Hartstoff festgestellt werden, der homogen aufgebracht ist, jedoch nicht das hervorragende Haftvermögen der erfindungsgemäß beschichteten Bohrer im Kantenbereich besitzt.

### Meßergebnisse

An einem Probewürfel wurde eine Kantenbeschichtung unter den gleichen Versuchsbedingungen wie bei dem vorangehend beschriebenden Beispiel vorgenommen. Der Probewürfel zeigte wiederum den rötlich bis gelblichen Saum im Kantenbereich, der für die Konzentrationsabsenkung typisch und äußeres Zeichen ist. Anschließend wurde mit Hilfe eines elektronischen Mikroanalysengerätes für Proben die Konzentration vom Kantenbereich aus über eine Strecke von 2,5 mm gemessen und mit Hilfe eines Plotters grafisch aufgetragen. Die Konzentration für das Aluminium ist in der Tabelle 1 und die des Titans in der Tabelle 2 wiedergegeben. Es sind deutlich Konzentrationsunterschiede von ca. 2 Massen% zu erkennen.

Der relativ unruhige Kurvenverlauf ist weniger ein Maß für die tatsächlichen Schwankungen als vielmehr Ausdruck der starken Vergrößerung, die zum Nachweis dieser Konzentrationsunterschiede erforderlich ist.

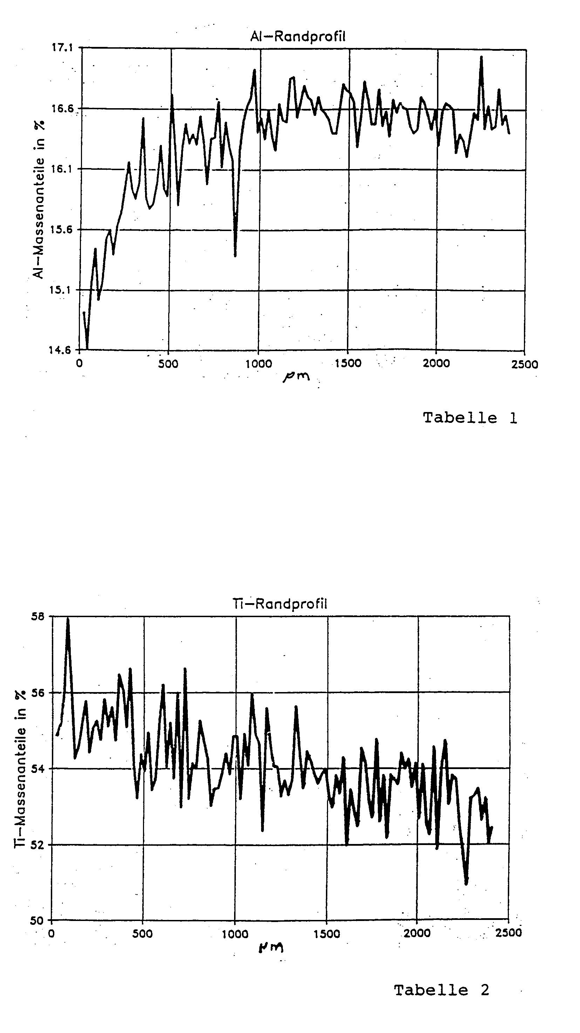

## Patentansprüche

1. PVD-Beschichtung oder Plasma-CVD-Beschichtung an einem Werkzeug oder Bauteil mit mindestens einer Kante im Bereich der Beschichtung, die aus einem Mehrkomponenten-Hartstoff mit mehr als einem metallischen Element besteht, dadurch **gekennzeichnet**, daß die Zusammensetzung der Beschichtung im Bereich jeder Kante im Vergleich zu den übrigen Bereichen der Beschichtung einen Konzentrationsunterschied der metallischen Elemente aufweist, der mindestens 2 Massen% beträgt.

2. Beschichtung nach Anspruch 1, dadurch **gekennzeichnet**, daß das Hartstoffsystem ein oder mehrere Metalloide wie Stickstoff, Kohlenstoff, Bor, Silizium oder Sauerstoff umfaßt.

3. Beschichtung nach Anspruch 1 oder 2, dadurch **gekennzeichnet**, daß zwei metallische Elemente enthalten sind, nämlich Aluminium und Titan, und daß der Konzentrationsunterschied als Absenkung des Aluminiumgehaltes um bis zu 10 Massen% vorliegt.

4. Beschichtung nach einem der vorhergehenden Ansprüche, dadurch **gekennzeichnet**, daß der Hartstoff ein Al-Ti-N-System oder ein Zr-Ti-N-System ist.

5. Beschichtung nach Anspruch 4, dadurch **gekennzeichnet**, daß das Hartstoffsystem außerdem andere metallische Elemente insbesondere der Nebengruppen IVa bis VIa des Periodensystems sowie weitere Metalloide enthält.

6. Beschichtung nach einem der vorhergehenden Ansprüche, dadurch **gekennzeichnet**, daß das Werkzeug oder Bauteil partiell oder vollständig aus einem HSS-Stahl oder einem Hartmetall,insbesondere mit dem Hauptbestandteil Wolframkarbid, besteht.

7. Beschichtung nach einem der vorhergehenden Ansprüche, dadurch **gekennzeichnet**, daß das Werkzeug oder das Bauteil partiell oder vollständig aus einem Werkzeugstahl, einem Cermet oder einer Keramik besteht.

8. Beschichtung nach einem der vorhergehenden Ansprüche, dadurch **gekennzeichnet**, daß auf den Grundwerkstoff vorher eine Zwischenschicht aus Ti-N, Ti-C-N oder Ti-C aufgebracht ist, auf die die Beschichtung erfolgt.

9. Verfahren zur Beschichtung eines Werkzeuges oder eines Bauteiles nach einem der Ansprüche 1 bis 7, bei dem in einer Vakuumkammer ein Hartstoff oder ein oder mehrere metallische Elemente eines Hartstoffes mit Hilfe einer energiereichen Strahlung zur Bildung eines Plasmas ionisiert sowie durch ein elektrisches Feld auf das Werkzeug oder das Bauteil gebracht wird, dadurch **gekennzeichnet**, daß das Potential des Plasmas gegenüber dem Werkzeug so stark gewählt wird, daß durch den Ionenbeschuß infolge der Spitzenwirkung der Kante auf der Kante der Konzentrationsunterschied selbsttätig herbeigeführt wird.

10. Verfahren nach Anspruch 8, dadurch **gekennzeichnet**, daß das Plasma aus ionisierten Metallatomen und Metalloid-Atomen besteht.

11. Verfahren nach Anspruch 8 oder 9, dadurch **gekennzeichnet**, daß zur Aufrechterhaltung des Plasmas ein Edelgas in die Vakuumkammer geleitet wird, das ebenfalls ionisiert wird.

12. Verfahren nach Anspruch 8 oder 9, dadurch **gekennzeichnet**, daß mindestens ein Bestandteil des Hartstoffes als reaktives Gas der Vakuumkammer zugeführt wird.

13. Verfahren nach Anspruch 10 oder 11, dadurch **gekennzeichnet**, daß durch die Wahl der Parameter und/oder Ionisationshilfen jeder Art bei einer PVD-Beschichtung die Ionisation so stark angehoben wird, daß ein Potential von ca. -50 bis -150 V zwischen dem Plasma und dem Werkstoff ausreicht bzw. bei einer CVD-Beschichtung einige 100 V bis zu 2000 V ausreicht.

14. Verfahren nach Anspruch 12, dadurch **gekennzeichnet**, daß das Potential bei einer PVD-Beschichtung -100 V beträgt.

## Claims

1. PVD coating or plasma CVD coating on a tool or component having at least one edge in the region of the coating, which comprises a multicomponent hard material having more than one metallic element, characterised in that the composition of the coating in the region of each edge, compared to the remaining regions of the coating, has a concentration difference of the metallic elements which amounts to at least 2 % by mass.

2. Coating according to claim 1, characterised in that the hard-material system comprises one or more metalloids such as nitrogen, carbon, boron, silicon or oxygen.

3. Coating according to claim 1 or 2, characterised in that two metallic elements are contained therein, namely aluminium and titanium, and in that the concentration difference is present as a lowering of the aluminium content by up to 10 % by mass.

4. Coating according to one of the preceding claims, characterised in that the hard material is an Al-Ti-N system or a Zr-Ti-N system.

5. Coating according to claim 4, characterised in that the hard-material system additionally contains other metallic elements, especially of the subgroups IVa to VIa of the Periodic Table of the Elements and further metalloids.

6. Coating according to one of the preceding claims, characterised in that the tool or component consists, in part or completely, of an HSS steel or a hard metal, especially with tungsten carbide as the main constituent.

7. Coating according to one of the preceding claims, characterised in that the tool or the component consists, in part or completely, of a tool steel, a cermet or a ceramic.

8. Coating according to one of the preceding claims, characterised in that onto the base material an interlayer of Ti-N, Ti-C-N or Ti-C is applied beforehand, onto which the coating is effected.

9. Process for coating a tool or a component according to one of claims 1 to 7, in which in a vacuum chamber a hard material or one or more metallic elements of a hard material is ionised, with the aid of a high-energy radiation, to form a plasma and, by means of an electric field, is applied to the tool or the component, characterised in that the potential of the plasma with respect to the tool is chosen so high that, as a result of the ion bombardement and as a consequence of the needle effect of the edge, the concentration difference on the edge is produced automatically.

10. Process according to claim 8, characterised in that the plasma consists of ionised metal atoms and metalloid atoms.

11. Process according to claim 8 or 9, characterised in that, in order to maintain the plasma, a noble gas is passed into the vacuum chamber, which noble gas is likewise ionised.

12. Process according to claim 8 or 9, characterised in that at least one constituent of the hard material is fed into the vacuum chamber as a reactive gas.

13. Process according to claim 10 or 11, characterised in that, by choosing the paramaters and/or ionisation aids of any type, in the case of a PVD coating, the ionisation is enhanced to such a degree that a potential from approximately -50 to -150 V between the plasma and the material is sufficient, or in the case of a CVD coating a few 100 V up to 2000 V is sufficient.

14. Process according to claim 12, characterised in that the potential in the case of a PVD coating is -100 V.

## Revendications

1. Revêtement PVD ou revêtement CVD au plasma sur un outil ou un composant avec au moins une arête dans la zone du revêtement qui est constitué par une substance dure à plusieurs constituants avec plus d'un élément métallique, **caractérisé en ce que** la composition du revêtement dans la zone de chaque arête présente, par comparaison aux autres zones du revêtement, une différence de concentration des éléments métalliques qui est d'au moins 2 % en masse.

2. Revêtement selon la revendication 1, **caractérisé en ce que** le système de substance dure comprend un ou plusieurs métalloïdes tels que l'azote, le carbone, le bore, le silice ou l'oxygène.

3. Revêtement selon la revendication 1 ou 2, **caractérisé en ce que** deux éléments métalliques sont contenus, à savoir l'aluminium et le titane, et que la différence de concentration se présente comme baisse de la teneur en aluminium allant jusqu'à 10 % en masse.

4. Revêtement selon l'une des revendications précédentes, **caractérisé en ce que** la substance dure est un système d'Al-Ti-N ou un système de Zr-Ti-N.

5. Revêtement selon la revendication 4, **caractérisé en ce que** le système de substance dure contient en outre d'autres éléments métalliques, en particulier des groupes associés IVa à VIa de la classification périodique des éléments ainsi que d'autres métalloïdes.

6. Revêtement selon l'une des revendications précédentes, **caractérisé en ce que** l'outil ou le composant est constitué partiellement ou entièrement par un acier H.S.S. ou un métal dur, en particulier avec le carbure de tungstène comme constituant principal.

7. Revêtement selon l'une des revendications précédentes, **caractérisé en ce que** l'outil ou le composant est constitué partiellement ou entièrement par un acier à outils, un cermet ou une céramique.

8. Revêtement selon l'une des revendications précédentes, **caractérisé en ce** qu'une couche intermédiaire en Ti-N, Ti-C-N ou Ti-C, sur laquelle a lieu le revêtement, est appliquée au préalable sur le matériau de base.

9. Procédé pour le revêtement d'un outil ou d'un composant selon l'une des revendications 1 à 7, dans lequel une substance dure ou un ou plusieurs éléments métalliques d'une substance dure sont ionisés dans une chambre à vide à l'aide d'un rayonnement de grande énergie pour former un plasma et sont appliqués par un champ électrique sur l'outil ou le composant, **caractérisé en ce que** le potentiel du plasma est choisi par rapport à l'outil d'une force telle que la différence de concentration sur l'arête est provoquée automatiquement par le bombardement ionique par suite de l'action des pointes de l'arête.

10. Procédé selon la revendication 8, **caractérisé en ce que** le plasma est constitué par des atomes de métal ionisés et des atomes de métalloïdes.

11. Procédé selon la revendication 8 ou 9, **caractérisé en ce** qu'un gaz rare, qui est également ionisé, est introduit dans la chambre à vide pour maintenir le plasma.

12. Procédé selon la revendication 8 ou 9, **caractérisé en ce** qu'au moins un composant de la substance dure est amené à la chambre à vide comme gaz réactif.

13. Procédé selon la revendication 10 ou 11, **caractérisé en ce que**, pour un revêtement par PVD, l'ionisation est élevée, par le choix des paramètres et/ou des auxiliaires d'ionisation en tout genre à tel point qu'un potentiel d'environ -50 à -150 V suffit entre le plasma et le matériau ou, pour un revêtement par CVD, que quelques 100 V à 2000 V suffisent.

14. Procédé selon la revendication 12, **caractérisé en ce que** le potentiel, pour un revêtement par PVD, est de -100 V.
